(19) Europäisches Patentamt / European Patent Office / Office européen des brevets

(11) **EP 2 642 659 B1**

(12) **FASCICULE DE BREVET EUROPEEN**

(45) Date de publication et mention
de la délivrance du brevet:
**24.10.2018 Bulletin 2018/43**

(51) Int Cl.:
*H03B 17/00* *(2006.01)*        *H04B 10/00* *(2013.01)*
*H01S 3/00* *(2006.01)*        *H01S 5/40* *(2006.01)*
*H01S 5/00* *(2006.01)*

(21) Numéro de dépôt: **13160381.3**

(22) Date de dépôt: **21.03.2013**

(54) **Oscillateur optoélectronique accordable et à faible bruit de phase**

Abstimmbarer optoelektronischer Oszillator mit schwachem Phasenrauschen

Tunable optoelectronic oscillator with low phase noise

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **22.03.2012 FR 1200858**

(43) Date de publication de la demande:
**25.09.2013 Bulletin 2013/39**

(73) Titulaires:
• **Thales**
**92400 Courbevoie (FR)**
• **Alcatel Lucent**
**91620 Nozay (FR)**

(72) Inventeurs:
• **Van Dijk, Frédéric**
**91120 Palaiseau (FR)**
• **Enard, Alain**
**92260 Chatenay-Malabry (FR)**
• **Accard, Alain**
**91460 Marcoussis (FR)**

(74) Mandataire: **Henriot, Marie-Pierre et al
Marks & Clerk France
Conseils en Propriété Industrielle
Immeuble Visium
22, Avenue Aristide Briand
94117 Arcueil Cedex (FR)**

(56) Documents cités:
**US-A- 5 777 778        US-A1- 2003 112 835
US-A1- 2011 170 564        US-B1- 7 272 160**

• HERCZFELD P R ET AL: "Terabertz photonics for imaging", MICROWAVES, RADAR AND WIRELESS COMMUNICATIONS, 2004. MIKON-2004. 15TH INTERNATIONAL CONFERENCE ON WARSAW, POLAND MAY 17-19, 2004, PISCATAWAY, NJ, USA,IEEE, vol. 3, 17 mai 2004 (2004-05-17), pages 1106-1111, XP010742088, DOI: 10.1109/MIKON.2004.1358580 ISBN: 978-83-906662-7-3
• JIN HONG ET AL: "Tunable millimeter-wave generation with subharmonic injection locking in two-section strongly gain-coupled DFB lasers", IEEE PHOTONICS TECHNOLOGY LETTERS, IEEE SERVICE CENTER, PISCATAWAY, NJ, US, vol. 12, no. 5, 31 mai 2000 (2000-05-31), pages 543-545, XP011426176, ISSN: 1041-1135, DOI: 10.1109/68.841280

**Description**

Le domaine de l'invention est celui des oscillateurs optoélectroniques.

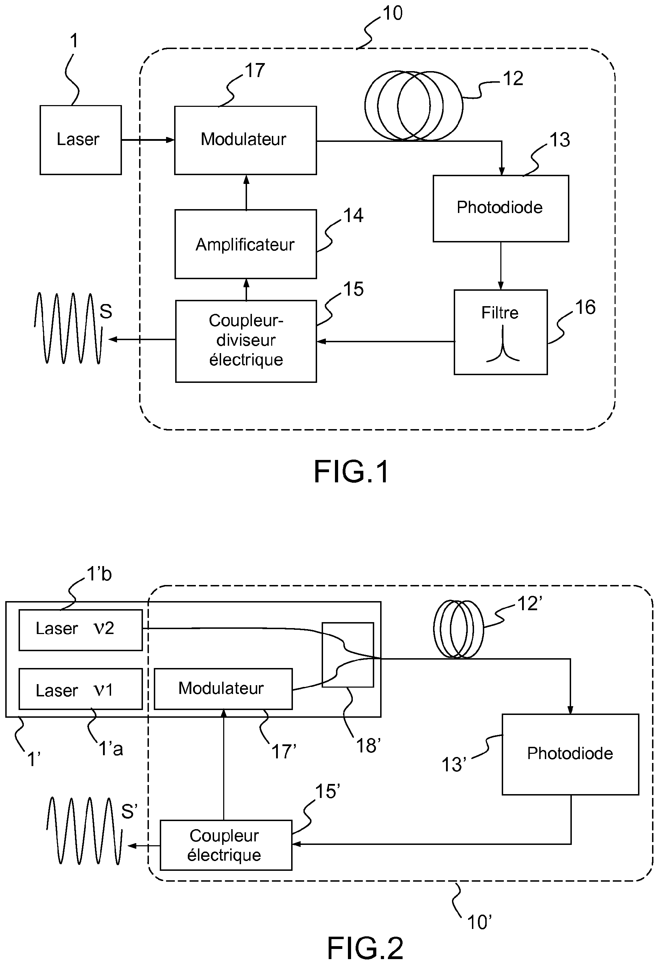

Un oscillateur optoélectronique, dans sa version la plus simple décrite en relation avec la figure 1, comprend une source laser 1, et une boucle fermée 10 comportant un modulateur électro-optique 17, une fibre optique 12, un photodétecteur 13, et de préférence un amplificateur 14. Le signal généré par la source laser 1 passe par le modulateur 17, est retardé dans la fibre optique 12, puis converti dans le domaine électrique grâce au photodétecteur 13. Le signal électrique est ensuite amplifié par l'amplificateur 14 et appliqué au modulateur électro-optique. Un coupleur électrique 15 intégré à la boucle, divise le signal électrique pour envoyer une partie vers la sortie S de l'oscillateur, l'autre restant dans la boucle.

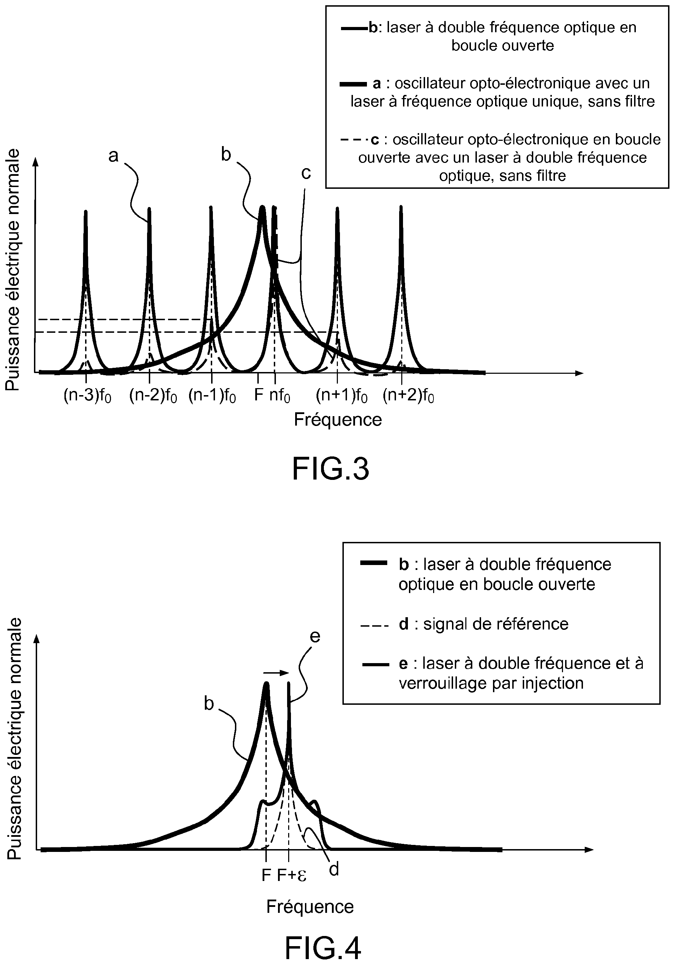

L'ensemble peut être considéré comme une cavité optoélectronique oscillante en anneau tant que le gain le long de la boucle peut être égal à l'unité, c'est-à-dire sans pertes. La fréquence fondamentale fo de l'oscillation électrique est égale à l'inverse du délai de propagation le long de la boucle; des harmoniques de cette fréquence, à k.fo, k étant un entier positif ou négatif (avec k=1 on retrouve la fréquence fondamentale), se produisent aussi tant que le gain dans la boucle est suffisant. Grâce au grand retard réalisable avec la fibre optique, il est possible d'obtenir une cavité ayant un fort facteur de qualité et, par voie de conséquence, un bruit de phase faible : on obtient alors pour chaque fréquence des harmoniques, une raie dont la largeur est fine comme illustré par la courbe a de la figure 3.

Pour sélectionner une fréquence électrique, on intègre dans la boucle fermée, un filtre électrique 16 qui permet de sélectionner parmi les harmoniques, celle ayant la fréquence choisie : cela revient à fixer k. On obtient ainsi une oscillation à une fréquence déterminée par le trajet le long de la boucle et dont la largeur de raie est fine c'est-à-dire dont la largeur à mi-hauteur est inférieure à 100 Hz.

Il existe des limites à cette solution :

- un filtre électrique est nécessaire afin de sélectionner une fréquence,
- le réglage de la fréquence (ou syntonisation) est limité par le filtre qui est à une fréquence fixe ou possède une gamme limitée de syntonisation,
- la vitesse de réglage est limitée par celle du filtre.

En conséquence, il demeure à ce jour un besoin pour un oscillateur optoélectronique donnant satisfaction aux exigences précitées, en termes de faible bruit de phase, de gamme de fréquences, et de préférence également en termes de vitesse de réglage pour obtenir une fréquence dans la dite gamme.
Le document Herczfeld et al « Terahertz photonics for imaging », Microwaves, radar and wireless communications, 2004, 15th international conférence on Warsaw, Poland, may 17-19 2004, Piscataway, NJ, USA IEEE vol 3, 17 mai 2004 pages 1106-1111, décrit la génération de sources Terahertz avec deux fréquences optiques différentes en s'écartant du cas idéal où les conditions d'utilisation et de nature identiques des deux lasers font qu'ils génèrent un signal de même fréquence optique. La PLL est utilisée pour modifier la tension de polarisation de la section de modulation qui réalise la fonction de variateur de fréquence. Les documents de brevet US7272160 B1 et US 2003/112835 A1 divulguent également des oscillateurs optoélectroniques comprenants des boucles fermées.

Plus précisément l'invention a pour objet un oscillateur optoélectronique à cavité optoélectronique oscillante en anneau, qui comprend une source laser destinée à émettre un signal et une boucle optoélectronique fermée apte à faire osciller le signal émis à une fréquence fondamentale ou à une de ses harmoniques, la boucle fermée comportant un modulateur optoélectronique de la source laser, une fibre optique apte à générer un retard, un photodétecteur relié à cette fibre optique, des moyens de filtrage d'une desdites fréquences d'oscillation, un coupleur-diviseur relié à la sortie de l'oscillateur. Il est principalement caractérisé en ce que :

- la source laser est un laser bi-fréquence optique à deux sections, l'une désignée première section étant apte à émettre un signal optique de fréquence v1, l'autre désignée deuxième section étant apte à émettre un signal optique de fréquence v2,
- le photodétecteur est photo mélangeur c'est-à-dire apte à détecter des signaux optiques de fréquence v1 et v2 et à fournir en sortie un signal électrique de fréquence F = |v1 - v2|,
- le modulateur est relié à la première section mais pas à la deuxième section, et
- en ce que le laser bi-fréquence, le photodétecteur, la fibre optique et le modulateur de la première section suffisent à réaliser les moyens de filtrage d'une fréquence.

Le signal de fréquence F permet ainsi de réaliser un filtrage parmi les harmoniques, c'est-à-dire de filtrer le signal électrique généré par l'oscillateur optoélectronique. Le filtre qui était nécessaire dans la configuration d'oscillateur selon l'état de la technique, n'a donc plus de raison d'être dans cette configuration selon l'invention. La combinaison du laser bi-fréquence avec le modulateur de la première section, de la fibre optique et du photodétecteur photomélangeur inscrits dans une boucle fermée, suffit à assurer le filtrage.

En s'abstenant d'introduire un filtre en tant que tel, on n'est donc plus limité par un tel filtre en termes de gamme de fréquences et de vitesse de réglage tout en conservant le faible bruit de phase d'un oscillateur selon l'état de la technique.

Le modulateur peut être intégré à la première section.

La boucle fermée comporte éventuellement un amplificateur optique ou électronique.

Selon une caractéristique de l'invention, l'oscillateur comporte un variateur de fréquence en entrée de la deuxième section et/ou un variateur de fréquence en entrée de la première section, ces variateurs pouvant être mécaniques ou thermiques ou électroniques.

De préférence, le laser bi-fréquence est un laser à semi-conducteur, qui comporte avantageusement des moyens de couplage des deux sections entre elles, aptes à injecter le signal de sortie de l'une vers l'autre et réciproquement.

Selon un mode de réalisation, l'oscillateur optoélectronique comporte une deuxième boucle fermée comportant des moyens de modulation optoélectronique de la deuxième section, mais pas de la première, une fibre optique, une photodiode photo mélangeuse reliée à cette fibre optique et apte à détecter des signaux optiques de fréquence v1 et v2 et à fournir en sortie un signal électrique de fréquence F = |v1 - v2|, un coupleur relié en sortie à la sortie de l'oscillateur.

Dans ce cas, la longueur de la fibre optique de la première boucle peut être différente de celle de la fibre optique de la deuxième boucle.

D'autres caractéristiques et avantages de l'invention apparaîtront à la lecture de la description détaillée qui suit, faite à titre d'exemple non limitatif et en référence aux dessins annexés dans lesquels :

la figure 1 représente schématiquement un exemple d'oscillateur selon l'état de la technique,
la figure 2 représente schématiquement un exemple d'oscillateur selon l'invention,
la figure 3 représente schématiquement en fonction de la fréquence, les signaux électriques respectivement obtenus en sortie du photodétecteur dans une configuration selon l'état de la technique sans filtre électrique (courbe a), en boucle ouverte (courbe b) et selon l'invention (courbe c),
la figure 4 illustre le phénomène de verrouillage par injection en boucle ouverte, en montrant en fonction de la fréquence, un signal de référence (courbe d), le signal électrique en sortie de la boucle ouverte sans signal de référence (courbe b), et verrouillé par le signal de référence appliqué à l'une des sections (courbe e),
les figures 5 représentent schématiquement en fonction de la fréquence, les signaux électriques théoriques (fig 5a) respectivement obtenus en sortie du photodétecteur dans une configuration en boucle ouverte avant verrouillage par injection (courbe b) et selon l'invention avec verrouillage par injection (courbe c'), et les signaux électriques correspondants effectivement obtenus (fig 5b).

D'une figure à l'autre, les mêmes éléments sont repérés par les mêmes références.

La figure 2 montre un exemple d'oscillateur optoélectronique selon l'invention. Il comporte certains éléments de l'oscillateur décrit en préambule, mais la source laser est une source laser à double fréquence optique, le photodétecteur est photomélangeur, le modulateur ne concerne qu'une section de cette source laser comme détaillé ci-dessous, et il ne comporte pas de filtre en tant que tel.

La source laser 1' à double fréquence optique est apte à émettre un signal optique à deux fréquences ; il est généré par deux sources d'émission, l'une désignée section 1'a qui est apte à émettre un signal optique de fréquence optique v1, l'autre désignée section 1'b étant apte à émettre un signal optique de fréquence optique v2. Un coupleur 18' est intégré à cette source 1' pour coupler les deux signaux respectivement émis par chaque section en un seul signal de sortie de fréquence v1 et v2.

La principale limite de ce type de source laser à double fréquence optique est la largeur de raie du signal électrique obtenu après photodétection qui, si la forme est lorentzienne, est égale à deux fois celle du signal optique. Dans le cas par exemple d'une source laser à semi-conducteur, dont la largeur de raie est comprise entre 500 kHz et 10 MHz, on obtient en sortie de l'oscillateur, une largeur de raie électrique comprise entre 1 MHz et 20 MHz.

Selon l'invention, les signaux optiques générés à l'aide de la source à double fréquence v1 et v2, sont retardés d'un même retard dans une fibre optique 12', puis convertis dans le domaine électrique grâce à un photodétecteur 13' qui effectue la conversion optoélectronique et également le mélange des deux fréquences afin de générer en sortie de ce photodétecteur, un signal électrique à une fréquence F égale à la différence entre les fréquences des deux signaux optiques. On a :

$$F = \left| v1 - v2 \right|$$

Bien sûr les deux signaux ne se combinent pour former le signal « mélangé » que dans la mesure où leurs polarisations respectives ne sont pas perpendiculaires, la combinaison la plus équilibrée étant pour des polarisations parallèles.

Ce photodétecteur photomélangeur peut être une photodiode à jonction p-n ou un empilement que de couches p ou que de couches n.

Le signal électrique de fréquence F est ensuite appliqué à un modulateur électro-optique 17' qui n'est le modulateur que d'une seule section, la section 1'a par exemple. Il s'agit d'un modulateur en phase ou en amplitude, mais de préférence un modulateur en amplitude. Le modulateur de la section 1'a peut être intégré à la source laser 1' comme montré sur la figure 2 ou lui être extérieur. Le modulateur peut aussi être confondu avec la section 1'a. Celle-ci assure alors à la fois la génération de la fréquence optique v1 et la modulation de ce signal.

Un coupleur 15' intégré à la boucle, divise le signal pour envoyer une partie vers la sortie S' de l'oscillateur, l'autre restant dans la boucle. Si le coupleur est électrique, il est positionné dans la partie électrique de la boucle (entre la sortie de la photodiode et le modulateur de la section 1'a) et le signal de sortie de l'oscillateur est une oscillation électrique. Si le coupleur est optique, il est positionné dans la partie optique de la boucle (entre la sortie du laser à double fréquence et la photodiode) et le signal de sortie de l'oscillateur est une oscillation optique. Dans la suite on considère que le coupleur de sortie est électrique.

Cet oscillateur comporte comme pour l'oscillateur décrit en préambule, une boucle fermée 10' qui comprend le modulateur électro-optique 17', le coupleur 18', la fibre optique 12', le photodétecteur photomélangeur 13', le coupleur-diviseur 15'. La fermeture de la boucle, soit l'application du signal au modulateur, modifie la fréquence F de manière à ce qu'elle soit égale à la fréquence k.fo la plus proche de F, soit n.f0.

Le signal dans la boucle est éventuellement amplifié sur le trajet du signal électrique par un amplificateur électronique (montré sur la figure 1), et/ou sur le trajet du signal optique par un amplificateur optique.

La section 1'b peut elle-même être pourvue d'un modulateur qui appartient à la boucle ouverte, mais ne fait pas partie de la boucle fermée et le signal électrique de fréquence F n'est pas appliqué à ce modulateur.

Dans un oscillateur, le démarrage des oscillations trouve son origine dans le bruit d'intensité. Dans le cas où on utilise deux lasers pour générer un battement hétérodyne à F dans la photodiode, le bruit blanc qu'on aurait si on utilisait un seul laser est remplacé par une raie centrée sur la fréquence F et qui favorise cette fréquence par rapport à toutes les autres. Comme on peut le voir figure 3, on obtient en sortie de l'oscillateur un signal électrique S' résultant :

- d'un signal sous forme d'harmoniques centrées en k.fo (courbe a fig 3) générées par la boucle fermée 10', multiplié par
- un signal de fréquence F (courbe b fig 3) généré en quelque sorte par une boucle ouverte formée du modulateur 17', du coupleur 18', de la fibre optique 12', du photodétecteur photomélangeur 13', et éventuellement de l'amplificateur (mais ne comportant pas d'élément 15' fermant la boucle).

Le signal résultant S' (courbe c fig 3) n'est pas symétrique et comporte notamment deux premiers pics secondaires de puissance différente.

Le signal de fréquence F permet de réaliser un filtrage parmi les harmoniques, c'est-à-dire de filtrer le signal électrique généré par l'oscillateur optoélectronique. Le filtre 16 qui était nécessaire dans la configuration d'oscillateur selon l'état de la technique, n'a donc plus de raison d'être dans cette configuration selon l'invention. La combinaison du laser bi-fréquence 1' avec le modulateur 17' de la section 1'a, et du photodétecteur 13' suffit à assurer le filtrage.

En s'abstenant d'introduire un filtre en tant que tel, on n'est donc plus limité par un tel filtre en termes de gamme de fréquences et de vitesse de réglage tout en conservant le faible bruit de phase d'un oscillateur selon l'état de la technique.

On peut en outre associer à l'une ou l'autre des sections de la source laser ou aux deux, un variateur apte à faire varier la fréquence v1 et/ou v2 et donc la fréquence F, c'est-à-dire la fréquence de ce signal électrique de filtrage. Ce variateur peut comporter des moyens de variation mécaniques ou thermiques ou électroniques.

Comme la fréquence optique d'un laser à semi-conducteur peut être réglée de manière rapide et sur une large gamme, généralement par des moyens électroniques, le réglage de la fréquence d'une telle source hétérodyne peut être réalisé à une vitesse dépassant 5 GHz/ns et sur une plage de fréquences pour v1 et v2, qui dépasse 20 GHz. Si une vitesse de réglage moins rapide est nécessaire, une gamme de fréquences de plus de 100 GHz peut facilement être atteinte.

Selon une autre caractéristique de l'invention, on utilise une source laser à double fréquence telle qu'une partie du signal généré par une section est injectée dans l'autre section et réciproquement. Un battement hétérodyne apparaît alors dans une section qui produit une légère modulation de son signal de sortie, à la fréquence du battement ; de même pour l'autre section. Dus à cette injection mutuelle et à cette modulation hétérodyne, des modes optiques latéraux additionnels apparaissent : on peut considérer qu'il s'agit d'un procédé de mélange à quatre ondes.

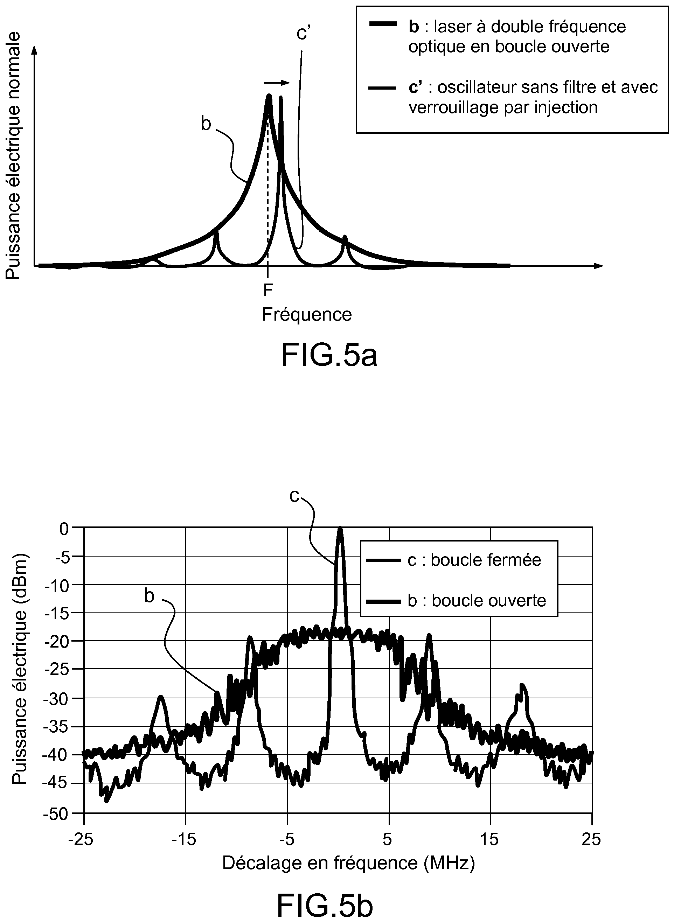

Lorsqu'en plus de cette injection mutuelle, une des sections (la section l'a dans notre exemple) est modulée directement ou extérieurement par un signal électrique (courbe d fig 4) dont la fréquence est très proche de F (ce qui est le cas du signal électrique de fréquence F qui est directement appliqué au modulateur de la section 1'a), la fréquence du signal généré par l'autre section (la section 1'b dans notre exemple), tend à se verrouiller sur l'un des modes latéraux de la section ainsi modulée (l'un des modes de la cavité opto-électronique en anneau associée à la section l'a dans notre exemple). Le résultat est illustré par la courbe e de la figure 4. Cette propriété désignée verrouillage par injection n'apparaît que pour un laser à semi-conducteur à double fréquence. Comme illustré figure 5a, il en résulte dans la configuration selon l'invention que la courbe b centrée en F est décalée en fréquence vers la fréquence k.fo la plus proche (courbe e fig 4), comme indiqué par la flèche figures 4 et 5a, v2 étant alors verrouillé sur k.fo et F étant donc égal à :

$$F = \left| v1 - v2 \right| = \left| v1 - k.fo \right| = \left| k'.fo \right|$$

Dans ce cas, le signal résultant S' en sortie de l'oscillateur est devenu symétrique, comme on peut le voir sur la courbe c' de la figure 5a.

Pour réaliser ce verrouillage par injection, on peut utiliser un laser à semi-conducteur comme section l'a et un laser à semi-conducteur ou non comme section 1'b. Le plus simple est d'utiliser un laser à semi-conducteur à deux sections.

On réalise ainsi un oscillateur opto-électronique comportant un laser bi-fréquences optiques dont une des deux sections lasers est modulée directement, une fibre optique pour générer un retard, une photodiode pour générer le battement hétérodyne dans le domaine électrique, un amplificateur électrique afin d'amplifier le signal avant de l'appliquer sur la section laser à moduler. Le laser bi-fréquence optique est verrouillé sur le battement hétérodyne obtenu grâce à son propre signal après un retard apporté par la fibre optique. On obtient ainsi un oscillateur opto-électronique qui bénéficie du faible bruit de phase qui peut être obtenu avec ce type d'architecture, et qui peut être largement et rapidement accordable grâce à l'utilisation d'une source laser bi-fréquence optique à semi-conducteurs.

Un oscillateur a été réalisé selon l'invention en utilisant un laser DFB (acronyme de l'expression anglo-saxonne Distributed FeedBack laser » ou « laser à rétroaction distribuée » en français) monolithique à semi-conducteur à double fréquence émettant respectivement à 1.5527 $\mu$m et à 1.5528 $\mu$m. Le signal électrique obtenu avec la boucle ouverte avant injection (courbe b) et avec la boucle fermée avec verrouillage par injection (courbe c) est montré figure 5b. Dans les conditions illustrées, le spectre est centré à 10 GHz.

On peut également réaliser un oscillateur à double boucle, en associant à la section 1'b, une boucle fermée du même type que celle décrite précédemment ; elle comprend donc un modulateur de la seule section 1'b, une fibre optique, un photodétecteur photomélangeur, un coupleur de sortie-diviseur, éventuellement un amplificateur, ces éléments étant distincts de ceux de la première boucle. Un diviseur est alors positionné en sortie du coupleur 18' pour envoyer une partie du signal vers la première boucle et l'autre partie vers la deuxième boucle. On obtient en sortie de la deuxième boucle fermée associée à la section 1'b, une deuxième oscillation de fréquence fondamentale différente de celle de l'oscillation de la première boucle (dite première oscillation), lorsqu'on choisit une longueur de fibre optique différente de celle de la première boucle.

## Revendications

1. Oscillateur optoélectronique qui comprend une source laser (1') destinée à émettre un signal et une boucle optoélectronique fermée (10') apte à faire osciller le signal émis à une fréquence fondamentale $f_0$ ou à une de ses harmoniques, la boucle fermée comportant un modulateur optoélectronique de la source laser, une fibre optique (12') apte à générer un retard, un photodétecteur (13') relié à cette fibre optique, des moyens de filtrage d'une desdites fréquences d'oscillation, un coupleur-diviseur (15') relié à la sortie (S') de l'oscillateur, en outre:

   - la source laser est un laser bi-fréquence optique à deux sections, l'une désignée première section (1'a) étant apte à émettre un signal optique de fréquence v1, l'autre désignée deuxième section (1'b) étant apte à émettre un signal optique de fréquence v2,
   - le photodétecteur (13') est photo mélangeur c'est-à-dire apte à détecter des signaux optiques de fréquence v1 et v2 et à fournir en sortie un signal électrique de fréquence F = |v1 - v2|,
   - le modulateur (17') est relié à la première section (1'a) mais pas à la deuxième section,

   l'oscillateur optoélectronique étant **caractérisé**

   - **en ce que** la fréquence fondamentale $f_0$ de l'oscillation électrique est égale à l'inverse du délai de propagation le long de ladite boucle fermée, et
   - **en ce que** le laser bi-fréquence (1'), la fibre optique (12'), le photodétecteur photo mélangeur (13') et le modulateur (17') de la première section sont configurés de sorte que l'on obtient en sortie de l'oscillateur un signal électrique résultant d'un signal sous forme d'harmoniques centrées en k.$f_0$ générées par la boucle fermée multiplié par un signal de fréquence F, k étant un entier naturel positif ou négatif , réalisant ainsi les moyens de filtrage d'une fréquence d'oscillation.

2. Oscillateur optoélectronique selon la revendication précédente, **caractérisé en ce que** le modulateur (17') est intégré à la source laser (1').

3. Oscillateur optoélectronique selon l'une des revendications précédentes, **caractérisé en ce que** la boucle fermée (10') comporte un amplificateur (14) optique ou électronique.

4. Oscillateur optoélectronique selon l'une des revendications précédentes, **caractérisé en ce qu'**un variateur de la fréquence v1 est associé à la première sortie (1'a) et/ou un variateur de le fréquence v2 est associé à la deuxième section (1'b) pour ainsi faire varier F.

5. Oscillateur optoélectronique selon la revendication précédente, **caractérisé en ce que** (le ou) les deux variateurs sont mécaniques ou thermiques ou électroniques.

**6.** Oscillateur optoélectronique selon l'une des revendications précédentes, **caractérisé en ce que** le laser à deux fréquences (1') est un laser à semi-conducteur.

**7.** Oscillateur optoélectronique selon la revendication précédente, **caractérisé en ce que** le laser à deux fréquences comporte des moyens de couplage des deux sections entre elles, aptes à injecter le signal de sortie de l'une vers l'autre et réciproquement.

**8.** Oscillateur optoélectronique selon l'une des revendications précédentes, **caractérisé en ce qu'**il comporte une deuxième boucle fermée comportant des moyens de modulation optoélectronique de la deuxième section mais pas de la première, une fibre optique, une photodiode photo mélangeuse reliée à cette fibre optique et apte à détecter des signaux optiques de fréquence v1 et v2 et à fournir en sortie un signal électrique de fréquence F = |v1 - v2|, un coupleur relié en sortie à la sortie de l'oscillateur.

**9.** Oscillateur optoélectronique selon la revendication précédente, **caractérisé en ce que** la longueur de la fibre optique de la première boucle est différente de celle de la fibre optique de la deuxième boucle.


**Patentansprüche**

**1.** Optoelektronischer Oszillator, beinhaltend eine Laserquelle (1'), welche dazu bestimmt ist, ein Signal auszusenden, und eine geschlossene optoelektronische Schleife (10'), welche in der Lage ist, das gesendete Signal in einer Grundfrequenz $f_0$ oder in einem seiner Oberschwingungen zum Oszillieren zu bringen,
wobei die geschlossene Schleife einen optoelektronischen Modulator der Laserquelle, einen Lichtwellenleiter (12'), welcher in der Lage ist, eine Verzögerung zu erzeugen, einen Photodetektor (13'), welcher mit diesem Lichtwellenleiter verbunden ist, Mittel zum Filtern der Oszillationsfrequenzen und einen Koppler-Teiler (15'), welcher mit dem Ausgang (S') des Oszillators verbunden ist, beinhaltet, und wobei zudem:

- die Laserquelle ein optischer Bi-Frequenz-Laser mit zwei Abschnitten ist, wobei der eine, genannt erster Abschnitt (1'a), in der Lage ist, ein optisches Signal der Frequenz v1 auszusenden, und der andere, genannt zweiter Abschnitt (1'b), in der Lage ist, ein optisches Signal der Frequenz v2 auszusenden,
- der Photodetektor (13') photomixend arbeitet, das heißt, in der Lage ist, optische Signale der Frequenzen v1 und v2 zu erkennen und am Ausgang ein elektrisches Signal der Frequenz F = |v1 - v2| bereitzustellen,
- der Modulator (17') mit dem ersten Abschnitt (1'a) verbunden ist, jedoch nicht mit dem zweiten Abschnitt,

wobei der optoelektronische Oszillator **dadurch gekennzeichnet ist:**

- **dass** die Grundfrequenz $f_0$ der elektrischen Oszillation gleich dem Kehrwert der Fortpflanzungsdauer entlang der geschlossenen Schleife ist, und
- **dass** der Bi-Frequenz-Laser (1'), der Lichtwellenleiter (12'), der photomixende Photodetektor (13') und der Modulator (17') des ersten Abschnitts so konfiguriert sind, dass man am Ausgang des Oszillators ein elektrisches Signal erhält, welches aus einem Signal in Form von Oberschwingungen resultiert, welche in $k.f_0$ zentriert sind, und von der geschlossenen Schleife erzeugt werden, multipliziert mit einem Signal der Frequenz F, wobei k eine natürliche positive oder negative Ganzzahl ist, wodurch die Mittel zum Filtern einer Oszillationsfrequenz geschaffen werden.

**2.** Optoelektronischer Oszillator nach dem vorhergehenden Anspruch, **dadurch gekennzeichnet, dass** der Modulator (17') in die Laserquelle (1') integriert ist.

**3.** Optoelektronischer Oszillator nach einem der vorhergehenden Ansprüche, **dadurch gekennzeichnet, dass** die geschlossene Schleife (10') einen optischen oder elektronischen Verstärker (14) beinhaltet.

**4.** Optoelektronischer Oszillator nach einem der vorhergehenden Ansprüche, **dadurch gekennzeichnet, dass** ein Regler der Frequenz v1 mit dem ersten Ausgang (1'a) assoziiert ist und/oder ein Regler der Frequenz v2 mit dem zweiten Abschnitt (1'b) assoziiert ist, um so F zu variieren.

**5.** Optoelektronischer Oszillator nach dem vorhergehenden Anspruch, **dadurch gekennzeichnet, dass** (der oder) die beiden Regler mechanisch oder thermisch oder elektronisch ist/sind.

**6.** Optoelektronischer Oszillator nach einem der vorhergehenden Ansprüche, **dadurch gekennzeichnet, dass** der Zweifrequenz-Laser (1') ein Halbleiter-Laser ist.

**7.** Optoelektronischer Oszillator nach dem vorhergehenden Anspruch, **dadurch gekennzeichnet, dass** der Zweifrequenz-Laser Mittel zum Koppeln der beiden Abschnitte miteinander beinhaltet, welche in der Lage sind, das Ausgangssignal des einen in den anderen zu injizieren und umgekehrt.

8. Optoelektronischer Oszillator nach einem der vorhergehenden Ansprüche, **dadurch gekennzeichnet, dass** er eine zweite geschlossene Schleife beinhaltet, welche Mittel zum optoelektronischen Modulieren des zweiten Abschnitts beinhaltet, jedoch nicht des ersten, einen Lichtwellenleiter, eine photomixende Photodiode, welche mit diesem Lichtwellenleiter verbunden und in der Lage ist, optische Signale der Frequenzen v1 und v2 zu erkennen und am Ausgang ein elektrisches Signal der Frequenz F = |v1 - v2| bereitzustellen, wobei ein Koppler am Ausgang mit dem Ausgang des Oszillators verbunden ist.

9. Optoelektronischer Oszillator nach dem vorhergehenden Anspruch, **dadurch gekennzeichnet, dass** die Länge des Lichtwellenleiters der ersten Schleife sich von derjenigen des Lichtwellenleiters der zweiten Schleife unterscheidet.

**Claims**

1. Optoelectronic oscillator which comprises a laser source (1') which is intended to transmit a signal and a closed optoelectronic loop (10') which is capable of oscillating the signal transmitted at a basic frequency $f_0$ or at one or the harmonics thereof, the closed loop comprising an optoelectronic modulator of the laser source, an optical fibre (12') which is capable of generating a delay, a photodetector (13') which is connected to this optical fibre, means for filtering one of the oscillation frequencies, a coupler/divider (15') which is connected to the output (S') of the oscillator, furthermore:

- the laser source is an optical bi-frequency laser having two sections, one designated the first section (1'a) being capable of transmitting an optical signal having frequency v1, the other designated the second section (1'b) being capable of transmitting an optical signal having frequency v2,
- the photodetector (13') is a photo mixer, that is to say, which is capable of detecting optical signals having frequency v1 and v2 and providing at the output an electrical signal having frequency F = |v1 - v2|,
- the modulator (17') is connected to the first section (1'a) but not to the second section,

the optoelectronic oscillator being **characterised**

- **in that** the basic frequency $f_0$ of the electrical oscillation is equal to the inverse of the propagation time along said closed loop, and
- **in that** the bi-frequency laser (1'), the optical fibre (12'), the photo mixer photodetector (13') and the modulator (17') of the first section are configured so that there is obtained at the output of the oscillator an electrical signal which results from a signal in the form of harmonics which are centred at k.$f_0$ and which are generated by the closed loop multiplied by a frequency signal F, k being a positive or negative natural number, thus producing the filtering means of an oscillation frequency.

2. Optoelectronic oscillator according to the preceding claim, **characterised in that** the modulator (17') is integrated in the laser source (1').

3. Optoelectronic oscillator according to either of the preceding claims, **characterised in that** the closed loop (10') comprises an optical or electronic amplifier (14).

4. Optoelectronic oscillator according to any one of the preceding claims, **characterised in that** a converter of the frequency v1 is associated with the first output (1'a) and/or a converter of the frequency v2 is associated with the second section (1'b) in order to thus vary F.

5. Optoelectronic oscillator according to the preceding claim, **characterised in that** the (or the two) converter(s) is/are mechanical or thermal or electronic.

6. Optoelectronic oscillator according to any one of the preceding claims, **characterised in that** the laser (1') with two frequencies is a semi-conductor laser.

7. Optoelectronic oscillator according to the preceding claim, **characterised in that** the laser with two frequencies comprises means which are for coupling the two sections together and which are capable of injecting the output signal from one to the other and vice versa.

8. Optoelectronic oscillator according to any one of the preceding claims, **characterised in that** it comprises a second closed loop which comprises means for optoelectronic modulation of the second section but not the first, an optical fibre, a photo mixer photodiode which is connected to this optical fibre and which is capable of detecting optical signals having a frequency v1 and v2 and providing at the output an electrical signal having frequency F = |v1 - v2|, a coupler which is connected at the output to the output of the oscillator.

9. Optoelectronic oscillator according to the preceding claim, **characterised in that** the length of the optical

**EP 2 642 659 B1**

fibre of the first loop is different from that of the optical fibre of the second loop.

FIG.1

FIG.2

FIG.3

FIG.4

FIG.5a

FIG.5b

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 7272160 B1

- US 2003112835 A1

**Littérature non-brevet citée dans la description**

- Terahertz photonics for imaging. **HERCZFELD et al.** Microwaves, radar and wireless communications, 2004, 15th international conférence on Warsaw. IEEE, 17 Mai 2004, vol. 3, 1106-1111